# EUROPÄISCHE PATENTSCHRIFT

(11) **EP 2 739 766 B1**
(45) Veröffentlichungstag und Bekanntmachung des Hinweises auf die Patenterteilung: **06.03.2019**
(21) Anmeldenummer: 12743430.6
(22) Anmeldetag: 26.07.2012
(51) Int. Cl.: C23C 16/458, C23C 16/54, C23C 16/455, H01L 31/18

(54) **VORRICHTUNG UND VERFAHREN ZUR HERSTELLUNG VON DÜNNEN SCHICHTEN**
DEVICE AND METHOD FOR PRODUCING THIN FILMS
DISPOSITIF ET PROCÉDÉ POUR LA RÉALISATION DE COUCHES MINCES

(30) Priorität: 01.08.2011 DE 102011080202
(43) Veröffentlichungstag der Anmeldung: 11.06.2014
(73) Patentinhaber: Gebr. Schmid GmbH, 72250 Freudenstadt (DE)
(72) Erfinder: SCHMID, Christian, 72250 Freudenstadt (DE); HABERMANN, Dirk, 79199 Kirchzarten (DE); HAUNGS, Jürgen, 72250 Freudenstadt (DE); ATTEMA, Chuck, Santa Cruz, California 95060 (US); STEWART, Tom, Santa Cruz, California 95013 (US); PROVANCHA, Kenneth, Soquel, California 95013 (US)
(74) Vertreter: Patentanwälte Ruff, Wilhelm, Beier, Dauster & Partner mbB
(86) Internationale Anmeldenummer: PCT/EP2012/064653
(87) Internationale Veröffentlichungsnummer: WO 2013/017514

(56) Entgegenhaltungen:
- WO-A1-2010/121190
- DE-A1-102008 030 677
- US-A- 5 393 563

## Beschreibung

Die Erfindung betrifft eine Vorrichtung zur Herstellung von dünnen Schichten auf Substraten sowie auf ein Verfahren zur Herstellung von dünnen Schichten im Durchlauf mit einer solchen Vorrichtung.

Das Abscheiden bzw. Herstellen von dünnen Schichten auf Substraten auch bei der Solarzellenherstellung mittels chemischer Gasphasenabscheidung bei Atmosphärendruck (APCVD) ist bekannt. Aufgrund relativ hoher Temperaturen von typisch deutlich mehr als 250°C für diese Verfahren werden die zu beschichtenden Substrate meist auf Metallbändern oder in Carriern transportiert. Die Metallbänder bestehen meist aus einer auf Nickel und Chrom basierenden Legierung, während die Carrier häufig aus Karbon-Verbundwerkstoffen oder aus Graphit bestehen. Diese Transportsysteme müssen nach dem Durchlaufen der Beschichtungsvorrichtung aufwendig gereinigt werden, was sequentiell oder kontinuierlich geschehen kann.

Dabei weisen Metallbänder zusätzlich das Problem auf, dass Substrate aus Halbleitermaterialien wie beispielsweise Silizium und GaAs im Falle einer Kontamination mit Metall wesentliche Verluste ihrer Leistungsfähigkeit aufweisen. Alternativ muss eine anschließende sehr aufwendige Reinigung durchgeführt werden oder auf die vorgenannten Carrier ausgewichen werden. Die Reinigungsschritte erhöhen die Produktionskosten erheblich. Für eine Massenproduktion wie bei der Solarzellenherstellung sind Transportsysteme mit Carriern wiederum weniger geeignet, da die mechanische Beanspruchung beim Be- und Entladen zu erhöhter Bruchgefahr führt. Dies gilt vor allem für die derzeitige Entwicklung zu immer dünneren Substraten bei der Solarzellenherstellung mit einer Dicke von weniger als 150 Mikrometer. Ein weiteres Problem von Metallbändern, die typisch als umlaufende Endlosbänder realisiert sind, ist der prinzipbedingt hohe Energiebedarf zur Banderwärmung. Zum einen muss eine relativ große Masse an Bandmaterial erwärmt werden, zum anderen kühlt das Band jeweils im Bereich außerhalb der entsprechenden Heizeinrichtung bzw. des Beschichtungsabschnitts wieder ab. Daraus kann eine Begrenzung der Temperatur auf ca. 600°C resultieren. Einige APCVD-Verfahren benötigen aber noch höhere Temperaturen. Außerdem kann bei auf dem heißen Metallband liegenden Substraten der unerwünschte Effekt der sogenannten Schüsselung auftreten, d.h. einer schüsselförmigen Aufwölbung der zu beschichtenden Solarzellenwafer.

Die EP 0 503 382 A1 offenbart ein APCVD-System mit umlaufendem Transportband, über dem in Transportrichtung voneinander beabstandet eine Vorprozesskammer, eine Hauptreaktionskammer und eine Nachprozesskammer mit zwischenliegenden Stickstoffspülvorgängen angeordnet sind. Unterhalb des Transportbandes ist entlang im Wesentlichen der gesamten Länge zwischen einer Beladestation und einer Entladestation eine Mehrzahl von Heizelementen vorgesehen, um die zu beschichtenden Substrate auf eine Temperatur von ca. 500°C aufzuheizen.

Die DE 10 2009 041 546 A1 offenbart ein Verfahren zur Herstellung von Solarzellen mit selektivem Ermitter. Dazu wird als ein möglicher Prozess die Erzeugung einer Dotierquelle wie Phosphorsilikatglas (PSG) mittels APCVD und das anschließende Durchführen eines ersten, leichten Diffusionsschrittes in einem Rohr- oder Durchlaufofen mit Rollen-, Kettenband- oder Hubbalkentransport vorgeschlagen.

Die DE 10 2008 030 679 A1 offenbart eine Vorrichtung zur Diffusionsbehandlung von Werkstücken mit einer Transporteinrichtung, für welche aus Gründen der Temperatur- und Korrosionsbeständigkeit gegenüber den verwendeten Prozessmedien der Einsatz von Rollen oder zylindrischen Walzen aus einem keramischen Werkstoff vorgeschlagen wird. In einem Reaktionsbereich ist über der Transportbahn eine Gaszufuhreinrichtung vorgesehen, der unter der Transportbahn eine Heizeinrichtung z.B. in Form eines Flächenstrahlers gegenüberliegt.

In der älteren Patentanmeldung DE 10 2011 077 833 der Anmelderin sind ein APCVD-Verfahren und eine entsprechende Vorrichtung zum Aufbringen einer Al₂O₃-Passivierungsschicht auf ein Substrat, insbesondere einen Solarzellen-Siliziumwafer, beschrieben, wobei das Substrat mittels einer durch Transportrollen gebildeten Transportbahn horizontal im Durchlaufbetrieb transportiert wird.

Weitere herkömmliche, einschlägige Vorrichtungen und Verfahren zur Herstellung von dünnen Substratschichten sind in der Patentschrift US 5.393.563 und den Offenlegungsschriften WO 2010/121190 A1 und DE 10 2008 030 677 A1 offenbart.

Der Erfindung liegt die Aufgabe zugrunde, eine Vorrichtung zur Herstellung von dünnen Schichten auf Substraten sowie ein entsprechendes Verfahren zur Herstellung von dünnen Schichten im Durchlaufbetrieb zur Verfügung zu stellen, mit denen Probleme des Standes der Technik vermieden werden können und insbesondere eine vielseitige Verwendbarkeit für beliebige APCVD-Verfahren gegeben ist.

Gelöst wird diese Aufgabe durch eine Vorrichtung mit den Merkmalen des Anspruchs 1 sowie durch ein Verfahren mit den Merkmalen des Anspruchs 9. Vorteilhafte Ausgestaltungen der Erfindung sind Gegenstand der weiteren Ansprüche und werden im folgenden näher erläutert. Dabei werden manche der genannten Merkmale nur im Zusammenhang mit der Vorrichtung oder mit dem genannten Verfahren beschrieben. Sie sollen jedoch unabhängig davon sowohl für die Vorrichtung als auch das Verfahren gelten können. Der Wortlaut der Ansprüche wird durch ausdrückliche Bezugnahme zum Inhalt der Beschreibung gemacht.

Es ist vorgesehen, dass die Schichten mit einem APCVD-Verfahren bei Temperaturen von mehr als 250°C aufgebracht werden. Dabei werden die Substrate im Durchlaufbetrieb auf einer horizontalen Transportbahn transportiert und mittels einer entsprechenden Beschichtungsvorrichtung beschichtet. Erfindungsgemäß ist die Transportbahn als Rollenbahn realisiert, d.h. sie weist Transportrollen auf, welche hintereinander angeordnet sind. Die Transportrollen bestehen aus einem temperaturbeständigen, nicht-metallischen Material. Damit kann die Gefahr einer Metallkontamination und die Problematik der vorgenannten aufwändigen Reinigung gelöst werden. Die Temperaturbeständigkeit des Materials der Transportrollen kann an den beabsichtigten Verwendungszweck bzw. an die zu verwendende Temperatur beim Beschichtungsverfahren angepasst werden.

Erfindungsgemäß ist bzw. sind an der der APCVD-Beschichtungsvorrichtung abgewandten Seite der Transportbahn, insbesondere unter der Transportbahn, eine Heizeinrichtung und eine Spülgaszufuhreinrichtung vorgesehen. Die Heizeinrichtung kann für die nötige Erwärmung der zu beschichtenden Substrate von der einen Seite her sorgen, während auf der anderen Seite die Schichten aufgebracht werden bzw. die Beschichtung erfolgt. Als Heizeinrichtungen bieten sich Strahlungsheizeinrichtungen an, wie sie dem Fachmann grundsätzlich bekannt sind. Dies können IR-Heizer, Quarzlampen oder dergleichen sein. Durch die Spülgaszufuhreinrichtung können die Substrate von der der zu beschichtenden Substratoberfläche abgewandten Seite her, z.B. von unten, mit einem sogenannten Spülgas beaufschlagt werden. Dadurch kann vermieden werden, dass ein zu großer Anteil des Gasstroms der APCVD-Beschichtungsvorrichtung in die Rollenbahn gerät oder an die Unterseite der Substrate, wo keine Beschichtung stattfinden soll.

Da die Transportbahn als Rollenbahn mit typischerweise voneinander beabstandet angeordneten Rollen realisiert ist, können die Substrate sehr effektiv durch die Heizeinrichtung und durch die Spülgaszufuhreinrichtung beaufschlagt werden. So kann Spülgas durch die Rollenzwischenräume hindurch direkt an die Substrate gelangen, und die Heizleistung der Heizeinrichtung kann ebenfalls durch die Rollenzwischenräume hindurch direkt und/oder auch indirekt über die Transportrollen zu den Substraten geführt werden.

Erfindungsgemäß ist es möglich, in Durchlaufrichtung vor der ersten Beschichtungsvorrichtung die Substrate vorzuheizen. Diese Vorheizung erfolgt vorteilhaft wiederum mit einer Heizeinrichtung bzw. einer Strahlungsheizeinrichtung. Dazu kann besonders vorteilhaft eine Art Vorheizkammer vorgesehen sein. Es wird als günstig angesehen, eine Heizeinrichtung für die Vorheizung oberhalb der Transportbahn bzw. der Substrate vorzusehen, z.B. wenn die anschließende Beschichtung der Substrate auf dieser Oberseite erfolgt. Außerdem kann damit der Anlagenaufbau vereinfacht werden, insbesondere auch bezüglich des Aufbaus und der Zugänglichkeit der Transportbahn bzw. der Rollenbahn mit den Transportrollen.

Ähnlich wie die vorbeschriebene Vorheizkammer ist auch hinter der Beschichtungsvorrichtung ein Beheizen der Substrate vorgesehen. Damit kann zum Einen die Beschichtung nachbehandelt werden und zum Anderen können die Substrate für nachfolgende Beschichtungsschritte oder Bearbeitungsschritte auf Temperatur gehalten werden.

Für die Spülgaszuführung hat es sich als vorteilhaft erwiesen, dass Spüldüsen vorgesehen sind, beispielsweise schlitzartig oder feldartig erstreckte Düsen, die im Wesentlichen die gesamte Fläche der Substrate im Bereich der Beschichtungsvorrichtungen z.B. von unten mit Spülgas beaufschlagen. Die Düsen sind durch eine Beheizung hindurchgeführt, so dass das Spülgas erwärmt wird, bevor es auf die Substrate trifft.

Erfindungsgemäß ist die Spülgaszufuhreinrichtung dafür ausgelegt, das Spülgas als Temperiermedium zum Heizen oder zum Kühlen auf die Substrate zu richten. Die Verwendung des Spülgases als Kühlmedium kann in bestimmten Anwendungsfällen unerwünschten Aufheizungseffekten, wie einem Wölben der Substrate, vorbeugen, speziell in Fällen, in denen die Substrate an ihrer zu beschichtenden Seite relativ hohen Beschichtungstemperaturen ausgesetzt sind. Durch Beaufschlagen der gegenüberliegenden Substratseite mit Spülgas, das eine gegenüber der Beschichtungstemperatur niedrigere Temperatur aufweist, können die Substrate während des Beschichtungsprozesses an ihrer gegenüberliegenden Seite in einem gewünschten Maß gekühlt werden.

Es ist möglich, die Transportrollen aus Graphitmaterial oder hochtemperaturfestem Faserverbundwerkstoff mit entsprechend temperaturbeständigen Fasern wie Kohlefasern, Graphitfasern, Basaltfasern oder Aramidfasern herzustellen. Damit lassen sich auch Temperaturen von über 250°C erreichen. Vorteilhaft bestehen die Transportrollen aus keramischem Werkstoff bzw. weisen zumindest eine äußere Oberfläche oder Beschichtung aus keramischem Werkstoff auf. Besonders vorteilhaft sind zumindest Rollenkörper der Transportrollen ganz aus Keramik gefertigt. Insbesondere ist es möglich, auch weitere Teile der Transportbahn aus keramischem Werkstoff herzustellen, beispielsweise Lager oder Achsen, auf denen die Transportrollen laufen. Dabei können solche Achsen entweder durchgängig durch Transportrollen mit einer entsprechenden Durchbohrung verlaufen oder aber als Achsstummel aus den Transportrollen herausstehen und auf Rollenlagern der Transportbahn gelagert sein. Wichtig ist in jedem Fall, dass die Bereiche der Transportrollen, die mit den Substraten in Berührung kommen oder sehr nahe an den Substraten sind, aus dem temperaturbeständigen, nichtmetallischen Material bestehen zur Vermeidung der vorbeschriebenen Gefahr von Kontamination.

Als keramische Werkstoffe bieten sich viele Materialien an. Besonders vorteilhaft wird Aluminiumoxid verwendet, da hiermit gute Erfahrungen gemacht werden und es auch allgemein in größerem Umfang industriell verwendet wird sowie gut verarbeitet werden kann. Es ist auch wenig bruchgefährdet und mechanisch stabil. Dem keramischen Werkstoff können auch Fasern beigemischt sein, insbesondere keramische Fasern wie Basaltfasern.

In weiterer Ausgestaltung der Erfindung sind vorteilhaft entlang der Transportbahn mindestens zwei solcher APCVD-Beschichtungsvorrichtungen vorgesehen. Dadurch ist es z.B. möglich, zweimal oder öfter eine dünne Schicht abzuscheiden und damit auf eine insgesamt höhere Schichtdicke zu kommen oder das Verfahren zu beschleunigen. Vorteilhaft sind die beiden Beschichtungsvorrichtungen dann ein Stück voneinander entfernt, beispielsweise das zweifache bis fünffache ihrer eigenen Durchlauflänge. Vorteilhaft ist es ist möglich, zwischen den Beschichtungsvorrichtungen weitere Heizeinrichtungen vorzusehen, damit die Substrate auch dazwischen auf Temperatur gehalten werden können.

Ein vorgenannter beheizter Bereich zwischen zwei Beschichtungsvorrichtungen kann vorteilhaft nach außen geschlossen sein, quasi nach Art einer Vorheizkammer für die zweite Beschichtungsvorrichtung, die ähnlich aufgebaut sein kann wie Vorheizkammer vor der ersten Beschichtungsvorrichtung. Auch hier wird es als vorteilhaft angesehen, wenn die Heizeinrichtungen auf der der zu beschichtenden Substratoberfläche zugewandten Seite, z.B. oberhalb der Transportbahn bzw. der zu beschichtenden Substrate, angeordnet sind, während im Bereich der Beschichtungsvorrichtungen selbst die Heizeinrichtungen auf der anderen, gegenüberliegenden Seite, z.B. unterhalb der Transportbahn, vorgesehen sind.

Durch die erfindungsgemäßen Transportrollen mit einer Oberfläche oder einem Vollmaterial aus nicht-metallischem, hochtemperaturbeständigem Material kann die Beschichtungsvorrichtung für Abscheidungstemperaturen ausgebildet sein, die 600°C deutlich überschreiten. Vor allem mit den vorgenannten keramischen Materialien für die Transportbahn bzw. die Transportrollen können auch Temperaturen von über 800°C oder sogar über 1000°C erreicht werden.

Als Alternative zu einer vorgenannten Strahlungsheizung als Heizeinrichtung, die elektrisch betrieben wird, ist es auch möglich, eine Beheizung mit einem heißen Gasstrom bzw. einem Plasma vorzusehen. Hierfür können Luft, Stickstoff oder ein anderes geeignetes Gasgemisch vorgesehen werden. Vorteilhaft ist eine solche Beheizung mit einem heißen Gasstrom außerhalb der APCVD-Beschichtungsvorrichtung vorgesehen, um die darin ablaufenden Beschichtungsvorgänge nicht zu beeinflussen, selbst wenn ein verwendetes Gas nicht direkt mit dem Beschichtungsprozess zusammen wirkt.

In weiterer Ausgestaltung der Erfindung kann vorteilhaft vorgesehen sein, an der APCVD-Beschichtungsvorrichtung ein Abluftsystem vorzusehen. Damit kann der Beschichtungsvorgang ungestörter ablaufen und der Gaszustrom besser gesteuert werden.

In nochmals weiterer vorteilhafter Ausgestaltung der Erfindung ist die Transportbahn relativ zu der restlichen Vorrichtung in der Vertikalen bewegbar bzw. die beiden können auseinander gefahren werden. Besonders vorteilhaft ist es, wenn dazu die Transportbahn bei ansonsten feststehender Vorrichtung nach unten abgesenkt werden kann. Dies bedeutet den geringstmöglichen Aufwand und die zu bewegenden Massen sind auch relativ gering. An einer abgesenkten Transportbahn können durch die wesentlich bessere Zugänglichkeit Reinigungs- und Wartungsarbeiten durchgeführt werden. Im Fall der vorgenannten, unter der Transportbahn angeordneten Heiz- und/oder Spülgaszufuhreinrichtungen im Bereich der Beschichtungsvorrichtungen kann vorgesehen sein, dass diese derart an der Transportbahn befestigt sind, dass sie mit bewegt bzw. abgesenkt werden. Dies stellt aber kein Problem dar. Insofern ist es auch vorteilhaft, wenn Heizeinrichtungen für eine Vorheizung oder sonstige Heizung der Substrate oberhalb der Transportbahn angeordnet sind, da sie dann beim Absenken nicht stören.

Durch das erfindungsgemäße Verfahren kann als dünne Schicht eine dielektrische Schicht hergestellt und auf ein Substrat aufgebracht werden. Vorteilhaft ist eine solche Schicht aus der Gruppe: SiO₂, Al₂O₃, SiNₓ, AIN ausgewählt. Besonders vorteilhaft werden damit Solarzellen beschichtet.

Alternativ kann durch das erfindungsgemäße Verfahren als dünne Schicht eine leitende Schicht auf eine Solarzelle aufgebracht werden, beispielsweise zu Kontaktierungszwecken. Vorteilhaft ist dies eine Schicht aus TCO. Dies ist vor allem bei Solarzellen von Vorteil.

Weiter alternativ kann mit dem erfindungsgemäßen Verfahren eine Dotierschicht auf eine Solarzelle als Substrat aufgebracht werden. Dies kann eine P-Dotierung, B-Dotierung oder eine Ge-Dotierung sein.

Weiter alternativ kann durch das erfindungsgemäße Verfahren auf eine Solarzelle als Substrat eine Anti-Reflexionsschicht als dünne Schicht aufgebracht werden. Sie kann ausgewählt sein aus der Gruppe: SiNx, MgO, MnO, TiO₂, ZrO₂, MoSi₂.

Wie erwähnt, eignen sich die erfindungsgemäße Vorrichtung und das zugehörige Verfahren besonders gut zur Beschichtung dünner Substrate, da diese allgemein auf Rollenbahnen sehr gut und schonend transportiert werden können. Dies ist auch bei keramischen Rollen gegeben. Durch die Inline-Beschichtung kann sehr gut eine Beschichtung in kurzer Zeit mit ausreichender Schichtdicke und schonender Handhabung der zu beschichtenden Substrate aufgebracht werden.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

Ausführungsbeispiele der Erfindung sind in den Zeichnungen schematisch dargestellt und werden im folgenden näher erläutert. In den Zeichnungen zeigen:
- Fig.1: eine erfindungsgemäße Vorrichtung zur Beschichtung mit einer einzigen APCVD-Beschichtungsvorrichtung und einer Transportbahn mit Transportrollen,
- Fig. 2: eine abgewandelte Vorrichtung ähnlich derjenigen aus Fig. 1 mit zwei APCVD-Beschichtungsvorrichtungen,
- Fig. 3: eine APCVD-Beschichtungsvorrichtung im vergrößerten Seitenschnitt mit Gasführung und vergrößerter Darstellung der Transportbahn und
- Fig. 4: eine Darstellung der Vorrichtung aus Fig. 1 mit abgesenkter Transportbahn.

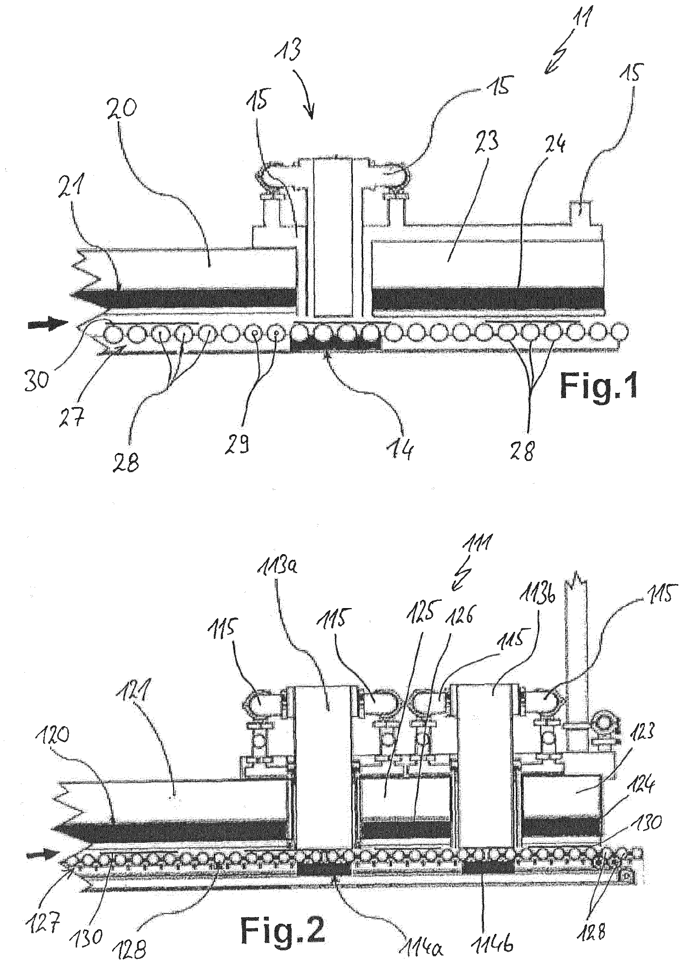

In der Fig. 1 ist eine erfindungsgemäße Vorrichtung 11 dargestellt, mit der dünne Schichten auf Substrate abgeschieden werden können. Insbesondere kann die Vorrichtung 11 bei der Solarzellenherstellung verwendet werden. Sie weist einen Injektor 13 als Beschichtungsvorrichtung auf, wie er beispielsweise aus der DE 10 2011 077 833 bekannt ist.

Links vor dem Injektor 13 ist eine Vorheizkammer 20 mit einer entsprechenden Heizeinrichtung 21 vorgesehen, während hinter dem Injektor 13 eine Nachheizung 23 mit Heizeinrichtung 24 vorgesehen ist. Unterhalb des Injektors 13 sowie der Vorheizkammer 20 und der Nachheizung 23 verläuft im unteren Bereich der Vorrichtung 11 eine Transportbahn 27. Sie weist einzelne Transportrollen 28 auf, mit denen Substrate 30, insbesondere für die Solarzellenherstellung, schonend auf eingangs beschriebene Art und Weise transportiert werden können. Die Substrate 30 liegen dabei lediglich auf den Transportrollen 28 auf und werden durch deren Drehung transportiert. Dies ist ganz offensichtlich ein möglichst schonender Vorgang, sodass auch sehr dünne bzw. empfindliche Substrate 30 transportiert und beschichtet werden können. Die Transportrollen 28 sind vorteilhaft angetrieben, was für den Fachmann jedoch leicht realisierbar ist und deswegen hier nicht näher dargestellt ist. Die Transportrollen 28 drehen sich dabei auf Rollenachsen 29, wie dies ebenfalls leicht vorstellbar ist, sodass es hier nicht weiter ausgeführt werden muss. Die Rollen 28 und die Rollenachsen 29 bestehen aus einem vorbeschriebenen Keramikmaterial, und zwar aus einem Vollmaterial, insbesondere Aluminiumoxid. Alternativ sind auch keramisch beschichtete Rollen 28 denkbar.

Des Weiteren ist an dem Injektor 13 ein Abluftsystem 15 vorgesehen, welches auch noch an der Nachheizung 23 vorgesehen ist. Dies wird nachfolgend noch näher erläutert.

Unter dem Injektor 13 ist eine Heizeinrichtung 14 angeordnet. Während die Heizeinrichtungen 21 und 24 nach unten wirken bzw. strahlen, um die darunter vorbeitransportierten Substrate 30 zu erwärmen, ist die Heizeinrichtung 14 des Injektors 13 unterhalb der Substrate 30 bzw. der Transportbahn 27 angeordnet und wirkt nach oben. Dies stört den Beschichtungsvorgang nicht und ermöglicht eine Beheizung der Substrate von unten während des an ihrer Oberseite ablaufenden Beschichtungsvorgangs.

In der Abwandlung einer Vorrichtung 111 entsprechend Fig. 2 ist dargestellt, dass zwei Injektoren 113a und 113b vorgesehen sind mit jeweils Heizeinrichtungen 114a und 114b darunter und unterhalb einer Transportbahn 127. Ebenso ist eine Vorheizkammer 120 mit einer entsprechenden Heizeinrichtung 121 vorgesehen und eine Nachheizung 123 mit einer Heizeinrichtung 124. Zwischen den beiden Injektoren 113a und 113b ist, um die zu beschichtenden Substrate 130 auf der Transportbahn 127 auf Temperatur zu halten, eine Zwischenheizung 125 mit einer entsprechenden Heizeinrichtung 126 vorgesehen. Die Zwischenheizung 125 kann dabei wie die Vorheizkammer 120 oder die Nachheizung 123 ausgebildet sein. Dies gilt auch für deren Heizeinrichtung 126, welche wiederum oberhalb der Transportbahn 127 angeordnet ist und die Substrate 130 darunter erwärmt.

Ein Abluftsystem 115 ist an beiden Injektoren 113a und 113b vorgesehen. Es erstreckt sich auch bis hinunter zu der Transportbahn 127, was nachfolgend jedoch noch näher erläutert wird. Auch bei dieser Vorrichtung 111 weist die Transportbahn 127 Transportrollen 128 auf. Diese sind vorteilhaft genau so ausgebildet wie bei der Fig. 1.

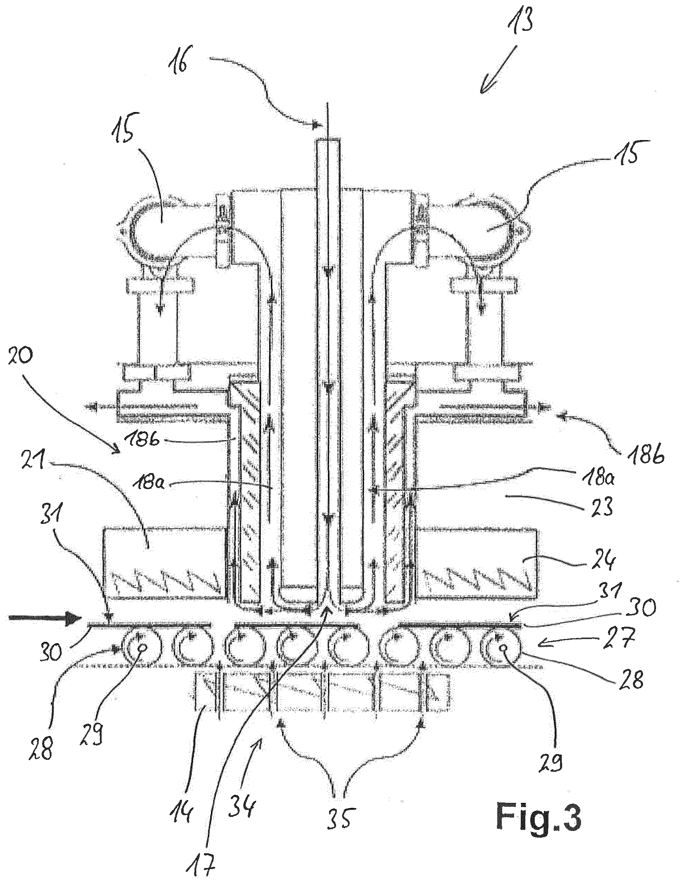

Eine Vergrößerung eines Injektors 13 als APCVD-Beschichtungsvorrichtung gemäß Fig. 3 zeigt zum Einen nochmal in Vergrößerung die Transportrollen 28 mit den Rollenachsen 29, die die Transportbahn 27 bilden. Die Substrate 30 liegen mit ihren Substratoberseiten 31 nach oben auf der Transportbahn 27 bzw. den Transportrollen 28. Die Rollenachsen 29 können dabei auf nicht dargestellte Art und Weise in seitlichen Rollenlagern an einem Rahmen odgl. der Vorrichtung 11 gelagert sein, wie dies an sich bekannt ist. Des Weiteren können diese Rollenachsen 29 durch die Transportrollen 28 hindurch verlaufen und an beiden Enden überstehen. Vorteilhaft können sie auch nach Art von kurzen Achsen eingesetzt sein oder überhaupt in den Rollenlagern befestigt sein, sodass die Transportrollen 28 nur lose auf sie aufgesteckt sind und sich darauf drehen können samt einem Antrieb.

Der Injektor 13 weist einen Gaseingang 16 auf, in den die Prozessgase für die APCVD-Beschichtung eingeleitet werden. Dies ist dem Fachmann an sich bekannt, siehe insbesondere auch die vorgenannte DE 10 2011 077 833. Der Gaseingang 16 erstreckt sich bis zu einem Gasausgang 17 an der Unterseite des Injektors 13 bzw. knapp oberhalb der Substratoberseite 31. Dort strömen die Prozessgase dann zur Seite hin weg zu unterschiedlichen Gasabsaugungen 18a relativ nahe an dem Gasausgang 17 und einer Gasaussaugung 18b etwas weiter nach außen entfernt. Die Gasabsaugungen 18a und 18b sind dabei mit dem vorgenannten Abluftsystem 15 verbunden.

Links und rechts des Injektors 13 ist wiederum die Vorheizkammer 20 mit Heizeinrichtung 21 bzw. die Nachheizung 23 mit Heizeinrichtung 24 dargestellt. Die Heizeinrichtungen 21 und 24 erwärmen dabei die Substratoberseiten 31 kurz vor und kurz nach der Beschichtung.

Unterhalb der Transportbahn 27 unter dem Injektor 13 ist eine Spülgaszufuhreinrichtung 34 vorgesehen mit einzelnen Spüldüsen 35. Durch diese wird Spülgas in die Vorrichtung 11 eingeleitet bzw. dieses Spülgas hält die Bereiche unterhalb der Substrate 30 im Bereich unterhalb des Injektors 13 einigermaßen frei von Gas aus dem Gasausgang 17 der APCVD-Beschichtungsvorrichtung. So können Verunreinigungen oder Ablagerungen an den Unterseiten der Substrate 30 vermieden werden.

Im Bereich der Spülgaszuführung 34 bzw. der Spüldüsen 35 ist auch die vorbeschriebene Heizeinrichtung 14 des Injektors 13 angeordnet. Die Spüldüsen 35 sind durch die Heizeinrichtung 14 hindurchgeführt. Dabei sind die Spüldüsen 35 entweder als eine Vielzahl von einzelnen Düsen ausgebildet oder als längliche Düsen, insbesondere Schlitzdüsen oder Ringdüsen.

Nach Austritt aus den Spüldüsen 35 kann das Spülgas durch die Zwischenräume zwischen den Transportrollen 28 hindurch direkt zur Unterseite der Substrate sowie durch Lücken zwischen aufeinanderfolgenden Substraten 30 hindurch in den Bereich über der Transportbahn 27 gelangen. Neben dem eigentlichen Spülgaszweck kann das Spülgas bei Bedarf eine Temperierfunktion, d. h. eine Heiz- oder Kühlfunktion, für die Substrate 30 ausüben. Dazu wird das Spülgas mit einer entsprechenden, gewünschten Temperatur auf die Substrate 30 gerichtet. Für diesen Temperierzweck kann das Spülgas bei Bedarf durch die Heizeinrichtung 14 aufgeheizt werden, insbesondere beim Durchtritt durch die Spüldüsen 35. Alternativ kann das Spülgas ohne Vorwärmung oder nach vorheriger aktiver Kühlung auf die Substrate 30 gerichtet werden, um diese unterseitig zu kühlen, vorzugsweise während, kurz vor und/oder kurz nach dem oberseitig ablaufenden Beschichtungsprozess. Für eine aktive Spülgaskühlung kann irgendeine der hierfür an sich bekannten Gaskühlvorrichtungen verwendet werden, was daher hier keiner näheren Erläuterungen bedarf. Alternativ oder zusätzlich zu einer unterseitigen Substratbeaufschlagung mit aufgeheiztem Spülgas können die Substrate 30 auch direkt durch die Heizeinrichtung 14 unterseitig beheizt werden, z.B. durch Strahlungsheizung durch die Rollenzwischenräume hindurch und/oder über die Transportrollen 28 selbst.

Die Heizeinrichtung 14 und die Spülgaszufuhreinrichtung 34 beschränken sich in ihrer Ausdehnung in Transportrichtung im Wesentlichen auf die entsprechende Ausdehnung des gegenüberliegend über der Transportbahn 28 angeordneten Injektors 13. Dies erweist sich als ausreichend für eine zufriedenstellende Substratbeheizung, wobei optional die oberseitig angeordneten Heizeinrichtungen 21, 24 hinzukommen. Im Vergleich zu einer herkömmlichen Anlage mit umlaufendem Transportband ergibt sich vorliegend durch die Rollenbahn der Vorteil einer deutlich höheren Beheizungseffektivität. Es muss kein sich beim Umlauf wieder abkühlendes Band beheizt werden, die Transportrollen 28 verbleiben an Ort und Stelle. Zudem können diejenigen Transportrollen 28, die im Beschichtungsbereich angeordnet sind, als kontinuierliche Wärmeübertragungselemente dienen und/oder durch ihre beabstandete Anordnung eine direkte Beheizung der Substrate von unten erleichtern.

Bezüglich der Funktionsweise der Beschichtung wird wiederum auf die vorgenannte DE 10 2011 077 833 verwiesen.

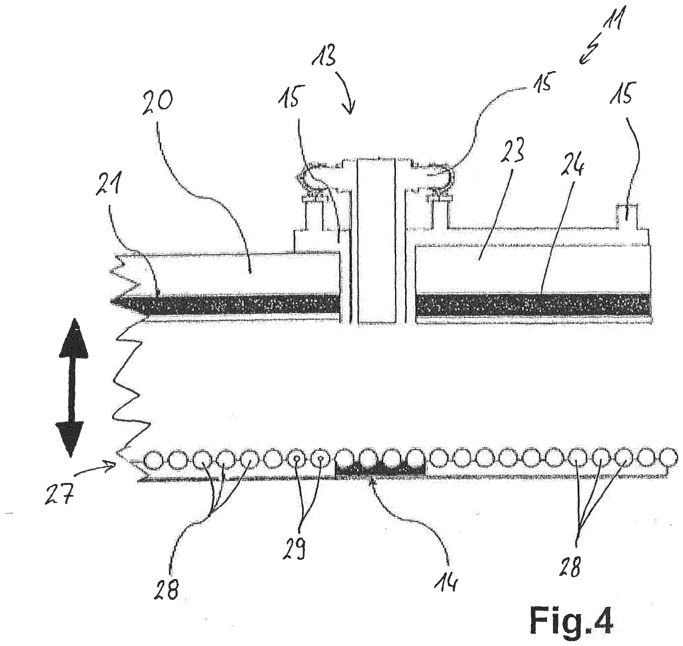

In Fig. 4 schließlich ist noch einmal die Vorrichtung 11 aus Fig. 1 dargestellt. Zu Wartungszwecken, insbesondere an der Transportbahn 27, ist diese nach unten gefahren bzw. abgesenkt, also auch die Transportrollen 28 samt nicht dargestellter Lagerung und daran befestigter Heizeinrichtung 14, die sonst unter dem Injektor 13 liegt. Es ist gut zu erkennen, dass nun die Transportbahn 27 bzw. die Transportrollen 28 sehr gut gewartet bzw. repariert oder gereinigt werden können. Das Absenken der Transportbahn 27 kann elektromotorisch, hydraulisch oder rein mechanisch erfolgen. Wie aus Fig. 4 gut zu ersehen ist, ist die Heizeinrichtung 14 problemlos mit absenkbar. Sie wird dann eben wiederum mit der Transportbahn 27 angehoben nach Durchführung der Wartungsarbeiten.

## Patentansprüche

1. Vorrichtung zur Herstellung von dünnen Schichten auf Substraten, insbesondere zur Solarzellenherstellung, mit
- einer horizontalen Transportbahn (27) mit Transportrollen (28), die aus einem temperaturbeständigen, nicht-metallischen Material bestehen, zum Transport der Substrate im Durchlaufbetrieb,
- einer über der Transportbahn angeordneten APCVD-Beschichtungsvorrichtung (13) zum Aufbringen der dünnen Schichten mittels eines APCVD-Verfahrens bei Temperaturen von mehr als 250°C,
- einer Heizeinrichtung (14) und einer Spülgaszufuhreinrichtung (34), die im Bereich der APCVD-Beschichtungsvorrichtung an der von der APCVD-Beschichtungsvorrichtung abgewandten Seite der Transportbahn angeordnet sind,
- wobei die Spülgaszufuhreinrichtung durch die Heizeinrichtung hindurchgeführte Spüldüsen (35) aufweist und dafür ausgelegt ist, die Substrate von unten mit Spülgas zu beaufschlagen und das Spülgas als Temperiermedium zum Heizen oder zum Kühlen der Substrate auf die Substrate zu richten,
- wobei auf der gleichen Seite der Transportbahn wie die APCVD-Beschichtungsvorrichtung in Durchlaufrichtung vor der APCVD-Beschichtungsvorrichtung eine Vorheizungseinrichtung (20, 21) für die Substrate vorgesehen ist und hinter der APCVD-Beschichtungsvorrichtung eine Nachheizungseinrichtung (23, 24) für die Substrate vorgesehen ist.

2. Vorrichtung nach Anspruch 1, **dadurch gekennzeichnet, dass** die Transportrollen aus einem keramischen Werkstoff bestehen oder mit einem solchen beschichtet sind, vorzugsweise Aluminiumoxid.

3. Vorrichtung nach Anspruch 1 oder 2, **dadurch gekennzeichnet, dass** entlang der Transportbahn mindestens zwei APCVD-Beschichtungsvorrichtungen (113a, 113b) mit einem vorgegebenen Abstand voneinander vorgesehen sind.

4. Vorrichtung nach Anspruch 3, **dadurch gekennzeichnet, dass** zwischen jeweils zwei APCVD-Beschichtungsvorrichtungen ein beheizter Bereich der Transportbahn vorgesehen ist, der mit einer oberhalb der Transportbahn angeordneten Heizeinrichtung (125, 126) versehen ist.

5. Vorrichtung nach einem der vorhergehenden Ansprüche, **dadurch gekennzeichnet, dass** die APCVD-Beschichtungsvorrichtung für Abscheidungstemperaturen von über 600°C ausgebildet ist, vorzugsweise von über 800°C, insbesondere von über 1000°C.

6. Vorrichtung nach einem der vorhergehenden Ansprüche, **dadurch gekennzeichnet, dass** als Heizeinrichtung, insbesondere außerhalb der APCVD-Beschichtungsvorrichtung, eine Beheizung mit einem heißen Gasstrom vorgesehen ist, vorzugsweise Luft, N₂ oder ein Gasgemisch.

7. Vorrichtung nach einem der vorhergehenden Ansprüche, **dadurch gekennzeichnet, dass** an der jeweiligen APCVD-Beschichtungsvorrichtung ein Abluftsystem (15) vorgesehen ist.

8. Vorrichtung nach einem der vorhergehenden Ansprüche, **dadurch gekennzeichnet, dass** die Transportbahn relativ zu der restlichen Vorrichtung nach unten absenkbar ist.

9. Verfahren zur Herstellung von dünnen Schichten im Durchlaufbetrieb mit einer Vorrichtung nach einem der vorhergehenden Ansprüche, **dadurch gekennzeichnet, dass** als dünne Schicht
- eine dielektrische Schicht hergestellt wird bzw. auf ein Substrat aufgebracht wird, vorzugsweise aus der Gruppe SiO₂, Al₂O₃, SiNₓ, AIN, oder
- eine leitende Schicht auf eine Solarzelle aufgebracht wird, insbesondere als TCO, oder
- eine Dotierschicht auf eine Solarzelle als Substrat aufgebracht wird, insbesondere eine P-Dotierung, eine B-Dotierung oder eine Ge-Dotierung, oder
- eine Anti-Reflexionsschicht auf eine Solarzelle als Substrat aufgebracht wird, insbesondere ausgewählt aus der Gruppe, die aus SiNx, MgO, MnO, TiO₂, ZrO₂ und MoSi₂, besteht.

## Claims

1. Device for producing thin layers on substrates, in particular for solar cell production, comprising
- a horizontal conveyor path (27) having conveyor rollers (28), which consist of a temperature-resistant, non-metallic material, for conveying the substrates in continuous operation,
- an APCVD coating device (13) arranged above the conveyor path for applying the thin layers by means of an APCVD process at temperatures of more than 250°C,
- a heating device (14) and a purge gas feeding device (34), which are arranged in the region of the APCVD coating apparatus on that side of the conveyor path which is remote from the APCVD coating device,
- wherein the purge gas feeding device includes purge nozzles (35) which are led through the heating device and is configured to expose the substrates to purge gas from below and to direct the purge gas as a temperature-control medium for heating or for cooling the substrates onto the substrates,
- wherein on the same side of the conveyor path as the APCVD coating device in the direction of passage a preheating device (20, 21) for the substrates is provided upstream of the APCVD coating device and a reheating device (23, 24) for the substrates is provided downstream of the APCVD coating device.

2. Device according to Claim 1, **characterized in that** the conveyor rollers consist of a ceramic material or are coated with such a material, preferably aluminium oxide.

3. Device according to Claim 1 or 2, **characterized in that** at least two APCVD coating devices (113a, 113b) are provided at a predefined distance apart from each other along the conveyor path.

4. Device according to Claim 3, **characterized in that** a heated region of the conveyor path is provided between any two APCVD coating devices and is provided with a heating device (125, 126) arranged above the conveyor path.

5. Device according to any of the preceding claims, **characterized in that** the APCVD coating device is designed for deposition temperatures of more than 600°C, preferably of more than 800°C, more preferably of more than 1000°C.

6. Device according to any of the preceding claims, **characterized in that** a heating system with a hot stream of gas, preferably air, N₂ or a gas mixture, is provided as the heating device, preferably outside the APCVD coating device.

7. Device according to any of the preceding claims, **characterized in that** a waste air system (15) is provided on the respective APCVD coating device.

8. Device according to any of the preceding claims, **characterized in that** the conveyor path can be lowered downwards relative to the rest of the device.

9. Method for producing thin layers in continuous operation using a device according to any of the preceding claims, **characterized in that**, as the thin layer,
- a dielectric layer is produced or is applied to a substrate, preferably from the group of SiO₂, Al₂O₃, SiNₓ, AlN, or
- a conductive layer is applied to a solar cell, preferably as a TCO, or
- a doping layer is applied to a solar cell as the substrate, in particular a P doping, a B doping or a Ge doping, or
- an anti-reflection layer is applied to a solar cell as the substrate, preferably selected from the group consisting of SiNₓ, MgO, MnO, TiO₂, ZrO₂ and MoSi₂.

## Revendications

1. Dispositif pour la réalisation de couches minces sur des substrats, en particulier pour la production de cellules solaires, comportant
- un chemin de transport (27) horizontal avec des rouleaux de transport (28) se composant d'un matériau non-métallique résistant à la température pour transporter les substrats en fonctionnement continu,
- un dispositif de revêtement APCVD (13) arrangé au-dessus du chemin de transport pour appliquer les couches minces au moyen d'un procédé APCVD à des températures de plus de 250°C,
- un dispositif de chauffage (14) et un dispositif d'alimentation en gaz de purge (34) arrangés à proximité du dispositif de revêtement APCVD sur le côté du chemin de transport détourné du dispositif de revêtement APCVD,
- dans lequel le dispositif d'alimentation en gaz de purge présente des buses de purge (35) traversant le dispositif de chauffage et est configuré pour alimenter les substrats par le bas de gaz de purge et pour diriger le gaz de purge vers les substrats en tant que milieu régulateur de températures pour chauffer et pour refroidir les substrats,
- dans lequel, sur le même côté du chemin de transport que le dispositif de revêtement APCVD en direction de passage, un dispositif de préchauffage (20, 21) pour les substrats est prévu en amont du dispositif de revêtement APCVD et un dispositif de postchauffage (23, 24) pour les substrats est prévu en aval du dispositif de revêtement APCVD.

2. Dispositif selon la revendication 1, **caractérisé en ce que** les rouleaux de transport se composent d'un matériau céramique ou sont revêtus d'un tel matériau, de préférence d'oxyde d'aluminium.

3. Dispositif selon la revendication 1 ou 2, **caractérisé en ce que** le long du chemin de transport au moins deux dispositifs de revêtement APCVD (113a, 113b) sont prévus à une distance prédéfinie l'un de l'autre.

4. Dispositif selon la revendication 3, **caractérisé en ce qu'**une région chauffée du chemin de transport est prévue respectivement entre deux dispositifs de revêtement APCVD, ladite région étant pourvue d'un dispositif de chauffage (125, 126) arrangé au-dessus du chemin de transport.

5. Dispositif selon l'une quelconque des revendications précédentes, **caractérisé en ce que** le dispositif de revêtement APCVD est configuré pour des températures de dépôt supérieures à 600°C, de préférence supérieures à 800°C, en particulier supérieures à 1000°C.

6. Dispositif selon l'une quelconque des revendications précédentes, **caractérisé en ce qu'**un chauffage utilisant un flux de gaz chaud, de préférence de l'air, N₂ ou un mélange gazeux, est prévu comme dispositif de chauffage, en particulier en dehors du dispositif de revêtement APCVD.

7. Dispositif selon l'une quelconque des revendications précédentes, **caractérisé en ce que** sur le dispositif de revêtement APCVD respectif un système d'air sortant (15) est prévu.

8. Dispositif selon l'une quelconque des revendications précédentes, **caractérisé en ce que** le chemin de transport est abaissable vers le bas par rapport au reste du dispositif.

9. Procédé pour la réalisation de couches minces en fonctionnement continu utilisant un dispositif selon l'une quelconque des revendications précédentes, **caractérisé en ce que** comme couche mince
- une couche diélectrique est préparée ou appliquée sur un substrat, de préférence du groupe SiO₂, Al₂O₃, SiNₓ, AlN, ou
- une couche conductrice est appliquée sur une cellule solaire, en particulier sous forme de TCO, ou
- une couche de dopage est appliquée sur une cellule solaire comme substrat, en particulier un dopage de P, un dopage de B ou un dopage de Ge, ou
- une couche anti-réfléchissante est appliquée sur une cellule solaire comme substrat, en particulier sélectionnée dans le groupe constitué par SiNₓ, MgO, MnO, TiO₂, ZrO₂ et MoSi₂.
